Europäisches Patentamt

European Patent Office

Office européen des brevets

(19)

(11) Numéro de publication : **0 077 589**
**B1**

(12)

# FASCICULE DE BREVET EUROPÉEN

(45) Date de publication du fascicule du brevet :
**18.09.85**

(21) Numéro de dépôt : **82201274.6**

(22) Date de dépôt : **14.10.82**

(51) Int. Cl.⁴ : **H 03 L   7/18**

(54) Synthétiseur de fréquence à accord rapide.

(30) Priorité : **16.10.81 FR 8119486**

(43) Date de publication de la demande :
**27.04.83 Bulletin 83/17**

(45) Mention de la délivrance du brevet :
**18.09.85 Bulletin 85/38**

(84) Etats contractants désignés :
**DE FR GB IT SE**

(56) Documents cités :
**EP-A- 0 041 882**
**FR-A- 2 170 908**
**US-A- 4 105 946**
**US-A- 4 270 215**
**US-A- 4 272 729**

(73) Titulaire : **TELECOMMUNICATIONS RADIOELECTRI-**
**QUES ET TELEPHONIQUES T.R.T.**
**88, rue Brillat Savarin**
**F-75013 Paris (FR)**
**FR**
**N.V. Philips' Gloeilampenfabrieken**
**Groenewoudseweg 1**
**NL-5621 BA Eindhoven (NL)**
**DE GB IT SE**

(72) Inventeur : **Defeuilley, Jean-Pierre**
**SOCIETE CIVILE S.P.I.D. 209 rue de l'Université**
**F-75007 Paris (FR)**
Inventeur : **Nguyen-van-Nguyen, Jean**
**SOCIETE CIVILE S.P.I.D. 209 rue de l'Université**
**F-75007 Paris (FR)**

(74) Mandataire : **Chaffraix, Jean et al**
**Société Civile S.P.I.D. 209, rue de l'Université**
**F-75007 Paris (FR)**

Jouve, 18, rue St-Denis, 75001 Paris, France

## Description

L'invention concerne un synthétiseur de fréquence comportant un oscillateur commandable par tension, un diviseur de la fréquence dudit oscillateur, une unité d'affichage de la fréquence désirée de laquelle est déduite une information numérique de commande du rapport de division du diviseur de fréquence, une boucle de verrouillage de phase comprenant un comparateur de phase recevant la fréquence de l'oscillateur divisée et une fréquence de référence et fournissant une tension de commande de fréquence de l'oscillateur, une boucle de recherche d'accord en fréquence munie d'un discriminateur de fréquence qui reçoit ladite fréquence divisée et ladite fréquence de référence et qui fournit des impulsions quand ces fréquences sont différentes, ces impulsions étant comptées dans un compteur qui est remis automatiquement à une position initiale quand il atteint une position terminale comportant aussi des moyens de conversion numérique-analogique pour positionner vers la plage de capture de boucle de verrouillage phase, l'oscillateur commandable par tension, moyens munis d'une première entrée pour recevoir l'information numérique constituée par ledit compteur.

Un synthétiseur de fréquence du type à diviseur de fréquence et comportant une boucle de verrouillage de phase et une boucle de recherche d'accord de fréquence est connu par exemple du brevet français n° 2 170 908 au nom de la demanderesse. La boucle de recherche d'accord en fréquence fournit, lors d'un changement de la fréquence affichée, une tension de recherche d'accord, variable en marches d'escalier, pour faire varier automatiquement la fréquence libre de l'oscillateur et l'amener dans la plage étroite où la boucle de verrouillage de phase peut entrer en action et verrouiller en phase la fréquence de l'oscillateur sur un multiple de la fréquence de référence ou d'une fraction de cette fréquence. Mais il est clair que la recherche d'accord de fréquence à l'issue de laquelle est obtenue la fréquence désirée peut être assez longue, notamment lorsque le synthétiseur de fréquences doit couvrir un large domaine de fréquences, puisque la tension de recherche automatique dont la vitesse de variation est forcément limitée doit parcourir un large domaine correspondant au domaine de fréquence du synthétiseur.

La présente invention vise à fournir les moyens d'accord rapide d'un synthétiseur de fréquence, du type à diviseur de fréquence variable.

Conformément à l'invention, dans un synthétiseur de ce genre, les moyens de conversion numérique-analogique sont munis en outre d'une deuxième entrée pour recevoir une information numérique dérivée de l'unité d'affichage.

Il est à noter que dans la demande de brevet européen n° 0 041 882, déposée le 22.05.81 et publiée le 16.12.81, on décrit un synthétiseur où le prépositionnement de l'oscillateur commandable par tension dérive de l'unité d'affichage ; mais cette mesure n'est pas combinée avec l'utilisation d'un compteur de boucle alimenté par les impulsions fournies par un discriminateur de fréquence.

On peut noter que le brevet américain n° 4 105 946 montre un synthétiseur de fréquence de type différent, ne comportant pas de diviseur de fréquence dans la boucle de verrouillage de phase. Dans ce synthétiseur, pour sélectionner une fréquence, au lieu de commander le rapport de division du diviseur de fréquence, on agit sur la tension de commande de l'oscillateur de façon que la fréquence sélectionnée soit un harmonique de la fréquence de référence. Ce synthétiseur connu comporte une boucle de recherche d'accord en fréquence et un dispositif manuel d'affichage de fréquence (du genre potentiomètre) commandant de façon continue la tension de commande de l'oscillateur pour permettre la sélection d'un harmonique de la fréquence de référence. Mais on ne trouve dans ce synthétiseur, aucun des moyens mis en œuvre selon l'invention pour augmenter la rapidité d'acquisition de la fréquence sélectionnée.

Dans un mode de réalisation avantageux, le synthétiseur de l'invention est remarquable en ce que les moyens de conversion numérique-analogique sont constitués par un seul convertisseur numérique-analogique munie d'une entrée pour bits de plus faible poids constituant ladite première entrée et d'une entrée pour bits de plus fort poids constituant ladite deuxième entrée.

La description suivante en regard des dessins annexés, le tout donné à titre d'exemple, fera bien comprendre comment l'invention peut être réalisée.

La figure 1 représente un premier mode de réalisation du synthétiseur de fréquence de l'invention, utilisant deux convertisseurs numérique-analogique pour convertir séparément les deux informations numériques de recherche d'accord en fréquence et de prépositionnement.

La figure 2 représente un deuxième mode de réalisation du synthétiseur de l'invention dans lequel les deux informations numériques de recherche d'accord en fréquence et de prépositionnement sont combinées à l'entrée d'un seul convertisseur numérique-analogique.

La figure 3 représente un troisième mode de réalisation du synthétiseur de l'invention avec un autre moyen de combinaison de l'information numérique de recherche d'accord en fréquence et d'une information numérique de prépositionnement.

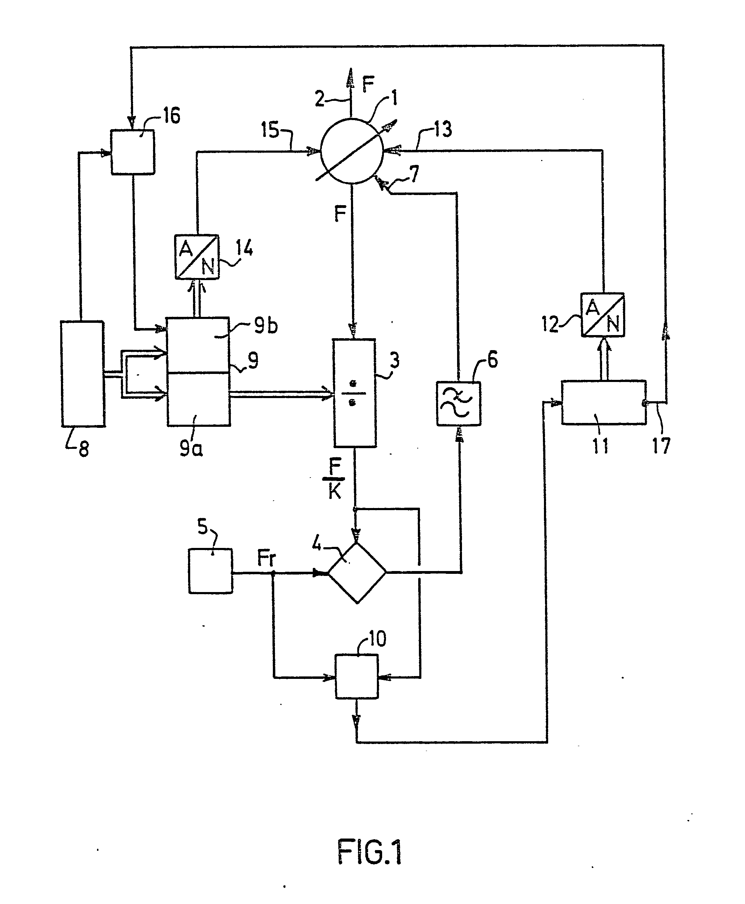

Sur la figure 1 montrant un mode de réalisation du synthétiseur de fréquence de l'invention, on a représenté l'oscillateur 1 à fréquence variable et commandable sur tension, communément appelé VCO. La fréquence de sortie F de l'oscillateur est disponible pour une utilisation sur une sortie 2. Elle est appliquée également, sous forme

d'impulsions, à un compteur d'impulsions 3 qui, après un cycle de K impulsions, reprend la même position et qui, jouant ainsi le rôle de diviseur de fréquence, fournit une fréquence F/K. La boucle de verrouillage de phase du synthétiseur comporte le comparateur de phase 4 qui reçoit la fréquence divisée F/K et une fréquence de référence stable $F_r$ fournie par un générateur 5. Le filtre de boucle passe-bas 6 connecté à la sortie du comparateur de phase fournit à l'entrée 7 de l'oscillateur variable 1 une tension de commande qui permet de corriger la phase de l'oscillateur. Lorsque le verrouillage en phase de l'oscillateur est réalisé, on a $F_r - F/K = 0$ et la fréquence de sortie F du synthétiseur est telle que $F = KF_r$.

Pour obtenir une certaine fréquence de sortie F, exactement multiple de la fréquence de référence $F_r$ dans l'exemple décrit, on doit amener le rapport de division K sur une valeur déterminée. On utilise à cet effet une unité d'affichage 8 sur laquelle on peut afficher une fréquence désirée avec un pas égal à la fréquence de référence $F_r$. Cette unité d'affichage fournit une information codée (par exemple en BCD) qui est appliquée à un dispositif de transcodage 9 fournissant une information codée (par exemple en binaire naturel), apte à commander le diviseur variable 3 sur le rapport de division K correspondant à la fréquence F désirée. Le dispositif de transcodage 9 peut être par exemple une mémoire dont une partie 9a contient à différentes adresses les différentes valeurs de l'information de commande du rapport de division K, et qui peut être adressée par l'information venant de l'unité d'affichage 8 pour fournir l'information de commande de K.

La boucle de verrouillage de phase ne peut fonctionner que si, en valeur absolue, la différence des fréquences $F_r$ et F/K est très faible. Pour obtenir l'accrochage de la boucle de verrouillage de phase après l'affichage d'une fréquence F, il est connu d'utiliser une deuxième boucle de recherche automatique d'accord en fréquence permettant d'amener la fréquence F de l'oscillateur dans l'étroite bande de fréquence où la boucle de verrouillage en phase fonctionne. Cette deuxième boucle comporte un discriminateur de fréquence 10 recevant la fréquuence divisée F/K et la fréquence de référence $F_r$ et engendrant des impulsions quand la différence de ces fréquences ne permet pas l'accrochage de la boucle de verrouillage de phase. Les impulsions fournies par le discriminateur de fréquence 10 sont comptées dans un compteur binaire 11 qui se remet automatiquement à une position initiale après le comptage de N impulsions. Le convertisseur numérique-analogique 12 convertit l'information numérique constituée par le contenu du compteur 11 en une tension analogique qui est appliquée sur la borne de commande de fréquence 13 de l'oscillateur 1. Cette tension de commande de fréquence a une valeur minimale correspondant à la position initiale du compteur, croît suivant N paliers quand le compteur compte N impulsions et reprend enfin sa valeur minimale à l'impulsion suivante. L'écart entre deux paliers successifs détermine un écart de fréquence inférieur à la plage de fréquence permettant l'accrochage de la boucle de verrouillage de phase. Quand la fréquence F fournie par l'oscillateur rentre dans l'étroite bande de fréquence permettant cet accrochage, la boucle de verrouillage en phase entre en action pour verrouiller la fréquence de l'oscillateur 1, le discriminateur de fréquence 10 ne fournit plus d'impulsions, le compteur 11 ne progresse plus et la tension de recherche sur la borne de commande 13 reste constante. Dans les synthétiseurs de fréquence connus, cette tension de recherche automatique de fréquence doit être à même d'engendrer l'exploration de toute la gamme des fréquences du synthétiseur, ce qui peut conduire à un temps d'acquisition trop important de la fréquence synthétisée F.

Pour réduire ce temps d'acquisition, il est prévu d'effectuer dans le circuit de transcodage 9 un transcodage de l'information de fréquence affichée dans l'unité 8 en une information numérique de prépositionnement dont les différentes valeurs caractérisent les différentes sous-gammes auxquelles peut appartenir la fréquence affichée. En supposant que le circuit de transcodage 9 est constitué par une mémoire, une partie 9b de cette mémoire peut contenir à différentes adresses, les différentes valeurs de l'information numérique de prépositionnement ; en adressant la partie de mémoire 9b au moyen de l'information provenant de l'unité d'affichage 8, on peut obtenir à la sortie de 9b, l'information numérique de prépositionnement.

Cette information numérique de prépositionnement est convertie par le convertisseur numérique-analogique 14 en tension analogique de prépositionnement qui est appliquée sur la borne de commande 15 de l'oscillateur 1 pour commander sa fréquence. Le convertisseur numérique analogique 14 fournit à chaque affichage de fréquence une tension de prépositionnement constante parmi n tensions possibles, n étant le nombre de sous-gammes du synthétiseur. Il est agencé pour que les tensions de prépositionnement déterminent à la sortie de l'oscillateur 1 les fréquences de début des sous-gammes. Enfin le convertisseur numérique-analogique 12 est agencé pour que l'excursion de la tension de recherche d'accord en fréquence produise à la sortie de l'oscillateur 1 une excursion de fréquence substantiellement égale à la largeur d'une sous-gamme.

Ainsi, avec ce synthétiseur, après un changement de la fréquence affichée, la recherche d'accord en fréquence s'effectue seulement sur une sous-gamme à partir de la fréquence basse de cette sous-gamme, de sorte que la rapidité d'acquisition de la fréquence synthétisée se trouve accrue.

Il peut arriver, en raison par exemple d'une dérive de la fréquence libre de l'oscillteur, qu'après un changement de fréquence affichée ayant engendré une première recherche d'accord en fréquence dans une sous-gamme déterminée, l'accrochage de la boucle de verrouillage de phase ne se soit pas produit à l'issue de cette première recherche. Avec le système décrit jusqu'à présent, il va se produire dans la même sous-gamme, d'autres recherches d'accord en fréquence qui ne détermineront pas davantage l'accrochage de la boucle de verrouillage de phase. On peut pallier cet inconvénient par une recherche d'accord sur deux sous-gammes consécutives, quand l'accord n'a pas été obtenu après une recherche sur la première sous-gamme. On peut utiliser pour cela une bascule 16 qui est remise à zéro par un signal provenant de l'unité d'affichage 8 et indiquant un changement de fréquence affichée. Cette bascule est commandée sur la position travail quand apparaît à la sortie 17 du compteur 11 un signal indiquant qu'il a atteint sa position terminale, ce qui signifie qu'une première recherche d'accord sur une première sous-gamme n'a donné aucun résultat. La bascule 16 en position travail agit sur l'adressage de la mémoire 9b de manière à ce que le signal numérique à la sortie de 9b représente la sous-gamme suivante. En même temps le compteur 11 est remis à la position initiale, et recommence à compter les impulsions fournies par le discriminateur de fréquence 10. Il en résulte finalement une deuxième recherche d'accord de fréquence dans la sous-gamme suivante. Dans le cas où l'accrochage de la boucle de verrouillage de phase ne serait pas obtenu à l'issue de cette deuxième recherche, le compteur 11 atteint sa position terminale et remet à zéro la bascule 16, ce qui permet une nouvelle recherche d'accord sur les deux sous-gammes consécutives déjà explorées. On pourrait bien entendu effectuer une recherche automatique d'accord sur plus de deux sous-gammes consécutives en utilisant au lieu de la bascule 16, un compteur ayant un nombre de positions approprié, progressant chaque fois que le compteur 11 atteint sa position terminale et agissant à chaque fois sur l'adressage de la mémoire 9b de façon que le signal numérique à la sortie de 9b représente une sous-gamme suivante.

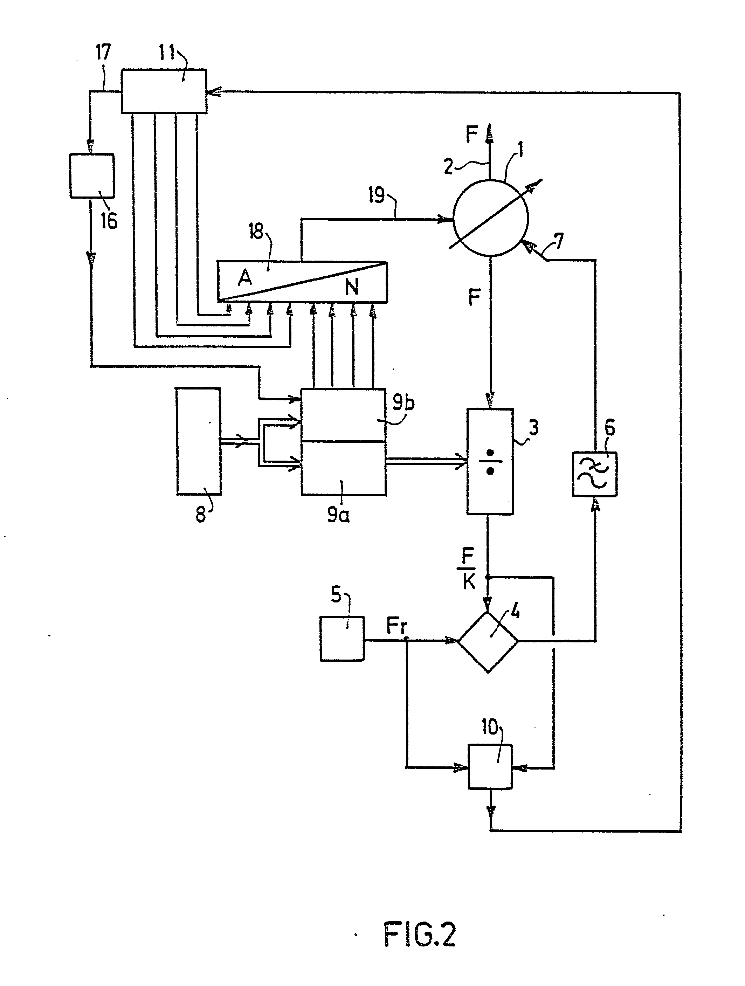

La figure 2 représente un mode de réalisation avantageux du synthétiseur de l'invention, permettant en même temps de faire l'économie d'un convertisseur numérique-analogique et de réaliser aisément la recherche d'accord en fréquence dans un domaine exactement égal à l'intervalle entre les fréquences de prépositionnement. Les éléments de la figure 2 exerçant la même fonction que ceux de la figure 1 sont référencés de la même manière. Le synthétiseur de la figure 2 diffère de celui de la figure 1 par le fait que l'information numérique de recherche d'accord en fréquence fournie par le compteur 11 et l'information numérique de prépositionnement fournie par la mémoire 9b sont combinées à l'entrée d'un convertisseur numérique-analogique 18, au lieu d'être appliquées aux deux convertisseurs numériques-analogiques 12 et 14.

La sortie du convertisseur numérique-analogique 18 est connectée à la borne de commande 19 remplaçant les deux bornes de commande 13 et 15 du synthétiseur de la figure 1. La combinaison des deux informations numériques est réalisée en appliquant les bits de l'information de prépositionnement (4 bits par exemple) aux entrées de plus fort poids du convertisseur 18 et les bits de l'information de recherche de fréquence (4 bits par exemple) aux entrées de plus faible poids de ce convertisseur. Après un changement de fréquence affiché, on obtient ainsi sur la borne de commande 19 de l'oscillateur une tension croissant par paliers à partir de la tension de prépositionnement correspondant à l'affichage et permettant de couvrir exactement le domaine de fréquence allant du début d'une sous-gamme au début de la sous-gamme suivante. On peut également utiliser dans le synthétiseur de la figure 2, une bascule 16 fonctionnant de la même manière que dans le synthétiseur de la figure 1 pour permettre une recherche d'accord de fréquence sur deux sous-gammes consécutives.

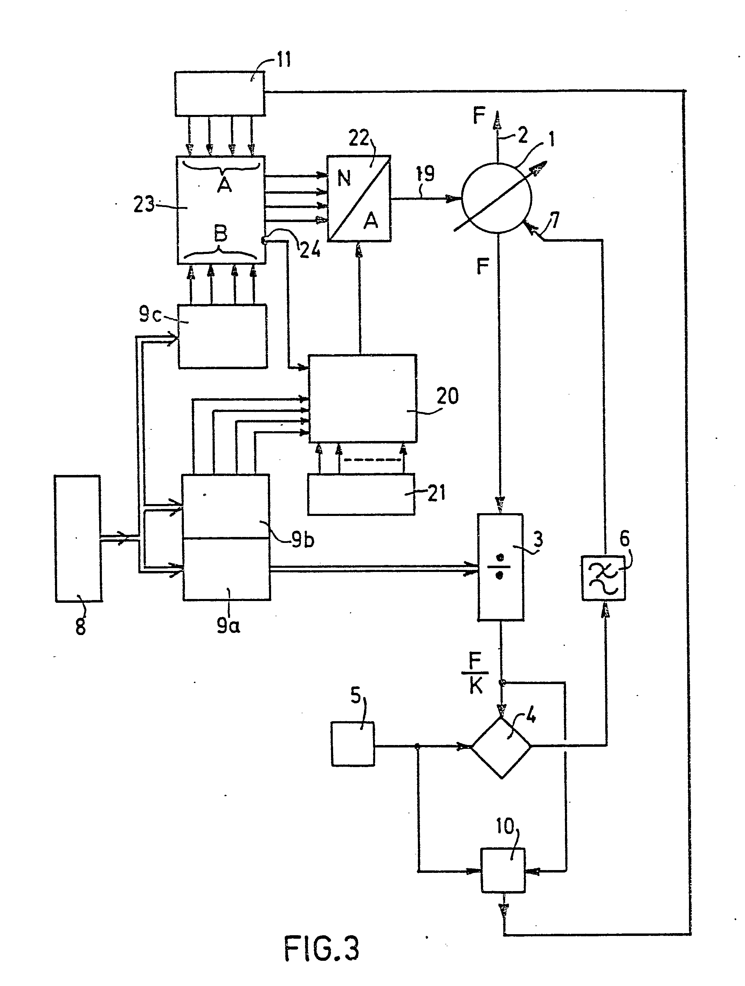

Un autre mode de réalisation du synthétiseur de l'invention est montré sur la figure 3 dans laquelle des éléments apparaissant déjà sur les figures 1 et 2 portent les mêmes références. Dans le synthétiseur de la figure 3, l'information numérique de prépositionnement fournie par la mémoire 9b est appliquée à un sélecteur 20 pour sélectionner l'une des tensions continues apparaissant aux sorties du générateur de tension 21. Ces tensions continues sont les tensions de prépositionnement qui permettent d'engendrer les fréquences de début des sous-gammes prévues. La tension continue de prépositionnement sélectionnée par le sélecteur 20 est dirigée vers le convertisseur analogique-numérique 22 dans lequel elle est utilisée comme tension de piédestal à la tension convertie formée par ce convertisseur. La sortie du convertisseur 22 est reliée à la borne 19 de commande de fréquence de l'oscillateur 1. A l'entrée du convertisseur 22 est appliqué un signal numérique de somme formé par le circuit additionneur 23. Ce circuit additionneur reçoit d'une part le nombre variable A (à 4 bits par exemple) fourni par le compteur 11 et représentant l'information de recherche d'accord en fréquence et d'autre part un nombre B (également à 4 bits par exemple) fourni par la mémoire 9c en réponse à l'information d'affichage de fréquence et dépendant de la région dans laquelle, à l'intérieur d'une sous-gamme, se trouve la fréquence sélectionnée. Dans l'exemple choisi, le circuit additionneur 23 fournit au convertisseur 22 des nombres de 4 bits. Sur la borne 24 du circuit additionneur apparaît un bit supplémentaire qui est appliqué au sélecteur 20 pour sélectionner la tension continue de prépositionnement suivant immédiatement celle qui a été sélectionnée par l'intermédiaire de la mémoire 9b. Ce bit supplémentaire peut être par exemple le bit de retenue de la somme sur 4 bits formée par le circuit additionneur 23.

On peut voir aisément que le début de la recherche d'accord en fréquence déterminée par le nombre variable A, est décalé par rapport au début d'une sous-gamme, d'une valeur dépendant du nombre B ; avec des nombres B convenablement choisis en fonction de la région de la sous-gamme à laquelle appartient la fréquence sélectionnée, on peut donc commencer la recherche dans cette région et obtenir plus rapidement l'accord en fréquence. L'action du bit de retenue apparaissant à la sortie 24 du circuit additionneur 23 est de prolonger l'accord en fréquence dans la sous-gamme suivant celle qui a été sélectionnée par la mémoire 9b. Cette prolongation peut être nécessaire lorsque la fréquence sélectionnée se trouve dans la région haute d'une sous-gamme. Lorsque la fréquence sélectionnée se trouve dans la région basse d'une sous-gamme cette prolongation n'est pas nécessaire. Il peut être avantageux dans certains cas que le bit supplémentaire apparaissant sur la sortie 24 du circuit additionneur soit non pas le bit de vraie retenue de la somme sur 4 bits (c'est-à-dire quand cette somme atteint 16), mais un bit qui apparaît quand la somme sur plus de 4 bits, atteint une certaine valeur (par exemple 20).

## Revendications

1. Synthétiseur de fréquence comportant un oscillateur commandable par tension, un diviseur de la fréquence dudit oscillateur, une unité d'affichage de la fréquence désirée de laquelle est déduite une information numérique de commande du rapport de division du diviseur de fréquence, une boucle de verrouillage de phase comprenant un comparateur de phase recevant la fréquence de l'oscillateur divisée et une fréquence de référence et fournissant une tension de commande de fréquence de l'oscillateur, une boucle de .recherche d'accord en fréquence munie d'un discriminateur de fréquence qui reçoit ladite fréquence divisée et ladite fréquence de référence et qui fournit des impulsions quand ces fréquences sont différentes, ces impulsions étant comptées dans un compteur qui est remis automatiquement à une position initiale quand il atteint une position terminale comportant aussi des moyens de conversion numérique-analogique pour positionner vers la plage de capture de boucle de verrouillage phase, l'oscillateur commandable par tension, moyens munis d'une première entrée pour recevoir l'information numérique constituée par ledit compteur caractérisé en ce que les moyens de conversion numérique-analogique sont munis en outre d'une deuxième entrée pour recevoir une information numérique dérivée de l'unité d'affichage.

2. Synthétiseur de fréquence selon la revendication 1 pour lequel l'oscillateur commandable par tension est susceptible d'osciller dans une gamme de fréquence divisée en sous-gammes caractérisé en ce que la variation du contenu du compteur fournissant les informations à la première entrée correspond à la largeur d'une sous-gamme et en ce que l'information numérique à la deuxième entrée correspond à la fréquence de début des sous-gammes.

3. Synthétiseur de fréquence selon la revendication 2 caractérisé en ce qu'il comporte un dispositif commandable sur plusieurs positions qui est commandé pour basculer sur la position suivante lorsque le compteur de la boucle de recherche atteint sa position terminale, ce dispositif fournissant une information supplémentaire pour que l'information à la deuxième entrée correspondant avant le basculement à une sous-gamme corresponde après le basculement à la sous-gamme suivante.

4. Synthétiseur de fréquence selon la revendication 3, caractérisé en ce que le dispositif commandable sur plusieurs positions est une bascule à deux positions.

5. Synthétiseur de fréquence selon l'une des revendications 1 à 4, caractérisé en ce que les moyens de conversion numérique-analogique sont constitués par deux convertisseurs numérique-analogique distincts, l'entrée de l'un constituant ladite première entrée, l'entrée de l'autre ladite deuxième entrée.

6. Synthétiseur de fréquence selon l'une des revendications 1 à 4, caractérisé en ce que les moyens de conversion numérique-analogique sont constitués par un seul convertisseur numérique-analogique muni d'une entrée pour bits de plus faible poids constituant ladite première entrée et d'une entrée pour bits de plus fort poids constituant ladite deuxième entrée.

7. Synthétiseur de fréquence selon la revendication 2, caractérisé en ce que les moyens de conversion numérique-analogique sont formés d'un convertisseur numérique-analogique muni d'une entrée pour tension de piedestal de sa tension de sortie, d'un sélecteur de tensions fixés dont chacune correspond à une sous-gamme pour fournir une de ces tensions à l'entrée pour tension de piedestal d'un circuit additionneur muni de deux entrées d'opérande, d'une sortie de somme et une sortie de retenue, une entrée d'opérande constituant ladite première entrée, l'autre entrée ainsi qu'une partie de l'entrée de sélection constituant par l'intermédiaire éventuel de circuit de transcodage ladite deuxième entrée et en. ce que la sortie de retenue du circuit additionneur constitue la partie restante de l'entrée de sélection du sélecteur de tension pour que la tension fixée corresponde à la sous-gamme suivant celle à laquelle appartient la fréquence affichée.

## Claims

1. A frequency synthesizer comprising a voltage-controlled oscillator, a divider dividing the frequency of said oscillator, a display unit displaying the desired frequency from which digital control data for the dividing ratio of the frequency divider is derived, a phase-locked loop comprising a phase comparator receiving the divided oscillator frequency and a reference frequency and supplying a frequency control voltage for the oscillator, a search tuning loop comprising a frequency discriminator receiving said divided frequency and said reference frequency and supplying pulses when the frequencies are different, these pulses being counted in a counter which is automatically reset to an initial position when it reaches an end position, also comprising digital-to-analog converting means for controlling the voltage-controlled oscillator to the lock-in range of the phase-locked loop, said means having an input for receiving digital information supplied by said counter, characterized in that the digital-to-analog converting means further have a second input for receiving digital information derived from the display unit.

2. A frequency synthesizer as claimed in Claim 1, for which the voltage-controlled oscillator is liable to oscillate in a frequency range divided into sub-ranges, characterized in that the variation of the content of the counter which applies the information to the first input corresponds to the width of a sub-range and in that the digital information at the second input corresponds to the initial frequency of the sub-ranges.

3. A frequency synthesizer as claimed in Claim 2, characterized in that it comprises an arrangement which can be driven to several positions and is driven to change-over to the following position when the counter of the search tuning loop reaches its final position, this arrangement supplying additional information so as to achieve that the information at the second input corresponding prior to the change-over to one sub-range corresponds after having changed state to the subsequent sub-range.

4. A frequency synthesizer as claimed in Claim 3, characterized in that the arrangement which can be driven to several positions is a two-position bistable multivibrator.

5. A frequency synthesizer as claimed in any one of the Claims 1 to 4, characterized in that the digital-to-analog converting means are constituted by two separate digital-to-analog converters, the input of one converter constituting said first input, the input of the other converter constituting said second input.

6. A frequency synthesizer as claimed in any one of the Claims 1 to 4, characterized in that the digital-to-analog converting means is constituted by a single digital-to-analog converter having an input for the least significant bits constituting said first input and an input for the most significant bits constituting said second input.

7. A frequency synthesizer as claimed in Claim 2, characterized in that the digital-to-analog converting means are constituted by a digital-to-analog converter having an input for receiving the pedestal level of its output voltage, a selector selecting fixed voltages each of which corresponds to a sub-range for applying one of these voltages to the pedestal voltage input, an adder circuit having two operand inputs, a sum output and a carry output, one operand input constituting said first input, the other input and also a portion of the selection input constituting via a translating circuit, if any, said second input and in that the carry output of the adder circuit constitutes the remaining portion of the selection input of the voltage selector so as to achieve that the fixed voltage corresponds to the sub-range subsequent to the sub-range to which the displayed frequency belongs.

**Patentansprüche**

1. Frequenzsynthesizer mit einem spannungsgesteuerten Oszillator, einem Teiler der Oszillatorfrequenz, einer Einheit zum Einstellen der gewünschten Frequenz, von der eine digitale Information zum Steuern des Teilerverhältnisses des Frequenzteilers abgeleitet wird, einer Phasenverriegelungsschleife mit einer Phasenvergleichsschaltung, welche die geteilte Oszillatorfrequenz und eine Bezugsfrequenz erhält und eine Frequenzregelspannung für den Oszillator liefert, einer Suchabstimmschleife mit einem Frequenzdiskriminator, der die genannte geteilte Oszillatorfrequenz und die genannte Bezugsfrequenz erhält und der Impulse liefert, wenn diese Frequenzen voneinander abweichen, wobei diese Impulse in einem Zähler gezählt werden, der automatisch in die Anfangslage zurückgestellt wird, wenn er eine Endlage erreicht, und der mit Digital-Analog-Umwandlungsmitteln versehen ist um den spannungsgesteuerten Oszillator in den Einfangbereich der Phasenverriegelungsschleife zu bringen, wobei die Mittel mit einem ersten Eingang versehen sind um die digitale Information des genannten Zählers zu empfangen, dadurch gekennzeichnet, dass die Digital-Analog-Umwandlungsmittel ausserdem mit einem zweiten Eingang versehen sind zum Empfangen einer von der Einstelleinheit abgeleiteten digitalen Information.

2. Frequenzsynthesizer nach Anspruch 1, wobei der spannungsgesteuerte Oszillator in einem in Teilbereiche aufgeteilten Frequenzbereich schwingen kann, dadurch gekennzeichnet, dass die Änderung des Inhaltes des Zählers, der die Informationen zu den ersten Eingang liefert, der Grösse eines Teilbereiches entspricht und dass die digitale Information an dem zweiten Eingang der Anfangsfrequenz der Teilbereiche entspricht.

3. Frequenzsynthesizer nach Anspruch 2, dadurch gekennzeichnet, dass er eine über mehrere Lagen steuerbare Anordnung aufweist, welche Anordnung gesteuert wird um zu der nächsten Lage zu kippen, wenn der Zähler der Suchschleife seine Endlage erreicht, wobei diese Anordnung eine zusätzliche Information schafft, damit die Information an dem zweiten Eingang, die vor dem Umkippen einem Teilbereich entspricht, nach dem Umkippen dem nächsten Teilbereich entspricht.

4. Frequenzsynthesizer nach Anspruch 3, dadurch gekennzeichnet, dass die über mehrere Lagen steuerbare Anordnung eine Kippschaltung mit zwei Lagen ist.

5. Frequenzsynthesizer nach einem der Ansprüche 1 bis 4, dadurch gekennzeichnet, dass die Digital-Analog-Umwandlungsmittel durch zwei unterschiedliche Digital-Analog-Umwandler gebildet werden, wobei der Eingang des einen Umwandlers den genannten ersten Eingang bildet und der Eingang des anderen Umwandlers den genannten zweiten Eingang.

6. Frequenzsynthesizer nach einem der Ansprüche 1 bis 4, dadurch gekennzeichnet, dass die Digital-Analog-Umwandlungsmittel durch einen einzigen Digital-Analog-Umwandler gebildet werden, der mit einem Eingang für die Bits kleinster Wertigkeit versehen ist, der den genannten ersten Eingang bildet und mit einem Eingang für die Bits grösster Wertigkeit, der den genannten zweiten Eingang bildet.

7. Frequenzsynthesizer nach Anspruch 2, dadurch gekennzeichnet, dass die Digital-Analog-Umwandlungsmittel durch einen Digital-Analog-Umwandler gebildet werden der mit einem Eingang versehen ist für die Stufenspannung der Ausgangsspannung, mit einem Wähler der festen Spannungen, von denen jede einem Teilbereich entspricht, um eine dieser Spannungen an dem Eingang für die Stufenspannung zu liefern, mit einer Addierschaltung, die mit zwei Operationseingängen, mit einem Summenausgang und einem Halte-Ausgang versehen ist, wobei ein Operationseingang den genannten ersten Eingang bildet, der andere Operationseingang ebenso wie ein Teil des Wahleingangs, gegebenenfalls über eine Transkodierschaltung, den genannten zweiten Eingang bildet und dass der Halte-Ausgang der Addierschaltung den übrigen Teil des Wahleingangs des Spannungswählers bildet, damit die feste Spannung dem Teilbereich entspricht, der demjenigen folgt, der zur eingestellten Frequenz gehört.

**0 077 589**

FIG.1

FIG.2

0 077 589

FIG.3

3